Europäisches Patentamt

European Patent Office

Office européen des brevets

(11) Veröffentlichungsnummer: **0 033 399**
**B1**

## EUROPÄISCHE PATENTSCHRIFT

(45) Veröffentlichungstag der Patentschrift:
17.04.85

(21) Anmeldenummer: **80200161.0**

(22) Anmeldetag: 27.02.80

(51) Int. Cl.⁴: **H 01 L 23/04,** H 01 L 23/56 // H01L23/16, H01L23/20, H01L23/24

(54) **Explosionsgeschützte Halbleiterbauelement-Anordnung.**

(30) Priorität: 01.02.80 **CH 824/80**

(43) Veröffentlichungstag der Anmeldung:
**12.08.81 Patentblatt 81/32**

(45) Bekanntmachung des Hinweises auf die Patenterteilung:
**17.04.85 Patentblatt 85/16**

(84) Benannte Vertragsstaaten:
**CH DE FR GB SE**

(56) Entgegenhaltungen:
**DE - A - 2 023 436**
**DE - A - 2 602 385**
**FR - A - 1 531 647**
**US - A - 4 099 201**

(73) Patentinhaber: **BBC Aktiengesellschaft Brown, Boveri & Cie., Haselstrasse, CH-5401 Baden (CH)**

(72) Erfinder: **Eckert, Heinz, Hauptstrasse 16, CH-5315 Böttstein AG (CH)**
Erfinder: **Herbst, Werner, Bachtobelstrasse 45, CH-8106 Adlikon ZH (CH)**

BUNDESDRUCKEREI BERLIN

## Beschreibung

Die Erfindung betrifft eine explosionsgeschützte Halbleiterbauelement-Anordnung nach dem Oberbegriff des Anspruchs 1.

Derartige Halbleiter-Bauelemente können für Schaltspannung bis etwa 1 kV je Element, für Nennströme bis etwa 3 kA und für Kurzschlußströme bis 300 kA ausgelegt sein. Je Element ist dabei eine Verlustleistung von etwa 1 kW als Wärme über Kühlelemente an ein Kühlfluid abzuführen. Solche Halbleiter-Bauelemente werden z. B. in Gleich- und Wechselrichtern von Hochspannungs-Gleichstrom-Übertragungsanlagen, zur Elektrolyse oder zum Schmelzen in Aluminiumhütten verwendet.

Erfolgt die Aufheizung eines Halbleiter-Bauelements zu schnell, so kann es explosionsartig zerstört werden, insbesondere, wenn ein Durchschlag am Rande des Halbleiter-Bauelements auftritt. Ein Maß für die Explosionsfestigkeit ist das sogenannte Grenzlastintegral $G = \int i^2 dt$.

Durch die DE-OS 2 652 348 ist eine Explosionsschutzanordnung für Halbleiter-Bauelemente bekannt, mit der für sinusförmige Impulse eine relativ hohe Explosionsfestigkeit mit einem Wert von $G \approx 35 \cdot 10^6 \, A^2 s$ erreicht wird, was einem Stromimpuls von 83,7 kA/10 ms entspricht. Das bekannte Halbleiter-Bauelement ist mit Explosionsschutzeinrichtungen ausgestattet. Seitlich angrenzend an eine Halbleiterscheibe ist ein Brennraum vorgesehen, in dem ein Lichtbogen zwischen Sollbrennstellen brennen kann. Anschließend an den Brennraum und von diesem durch einen Keramik-Isolator getrennt, kann ein volumenmäßig größerer Expansionsraum vorgesehen sein, in dem bei einer Explosion im Brennraum freigesetzte heiße Gase und weggeschleuderte Bruchstücke des Gehäuses aufgefangen werden. Um einen weiteren Abbau des Überdrucks zu erreichen, kann der Expansionsraum Dichtlippen und andere Druckreduziereinrichtungen aufweisen. Bedingt durch die relativ kleinen Druckausgleichvolumina derartiger Anordnungen für Halbleiter-Hochleistungsbauelemente kann es dennoch zu deren Zerstörung kommen, insbesondere bei sehr steilem Stromanstieg. Durch herumfliegende Trümmerteile können benachbarte Halbleiter-Bauelemente, Sicherungen oder Beschaltungsteile beschädigt werden.

Aus der DE-A-2 602 385 ist ein Halbleiter-Bauelement bekannt, bei dem ein Metallring, der über das Gehäuse geschoben wird, als Schutz im Falle einer explosionsartigen Zerstörung der Halbleiterscheibe dient.

Die Erfindung, wie sie in den Patentansprüchen gekennzeichnet ist, löst die Aufgabe, eine Explosionsschutzanordnung für Halbleiter-Bauelemente anzugeben, die bei einer Zerstörung eines Halbleiter-Bauelementes andere Bau-, Sicherungs- und Schaltelemente vor einer Beschädigung durch herumfliegende Trümmerteile schützt und gleichzeitig als Zentrierung der Halbleiter-Bauelemente verwendbar ist.

Die Wirkung der damit beanspruchten Maßnahme besteht darin, daß Trümmerteile eines explodierenden Halbleiter-Bauelements im wesentlichen in dem durch den Explosionsschutzmantel begrenzten Berstraum zu liegen kommen. Das beschädigte Halbleiter-Bauelement kann ohne besondere Schwierigkeiten durch ein unbeschädigtes ersetzt werden. Der Explosionsschutzmantel schützt gleichzeitig das Halbleiter-Bauelement vor Verschmutzung. Ein eventuell auftretender Lichtbogen wird in seiner Ausbreitung durch den Explosionsschutzmantel begrenzt. Ein Vorteil der Erfindung besteht darin, daß keine besonders aufwendige Explosionsschutzanordnung am Halbleiter-Bauelement selbst vorgesehen sein muß.

Der Explosionsschutzmantel wird gleichzeitig zur Zentrierung der Kühlelemente des Halbleiter-Bauelements sowie zur Befestigung von Zentrierteilen des Halbleiter-Bauelements verwendet werden.

Zum einschlägigen Stand der Technik wird zusätzlich auf die DE-A 2 023 436 verwiesen, die in Fig. 3 ein Halbleiter-Bauelement zeigt, bei dem ein Zwischenstück aus Isoliermaterial zur Zentrierung einer Silizium- und einer Molybdänscheibe vorgesehen ist. Dieses Zwischenstück ist mit Abstand von einem Keramik-Zylinder umgeben, der über Flansche mit den Elektroden der Halbleiteranordnung verbunden ist. Eine Einrichtung zum Zentrieren des Halbleiter-Bauelementes innerhalb einer Abschottung ist nicht vorgesehen.

Aus der FR-A 1 531 647 ist es bekannt, bei einem Halbleiter-Bauelement den Raum um die Halbleiterscheibe mit einem Lichtbogenlöschmittel, zum Beispiel einem Öl oder $SF_6$-Gas zu füllen. Auch hier ist keine Einrichtung zum Zentrieren des Halbleiter-Bauelementes und keine Abschottung um den randseitigen Isolator des Halbleiter-Bauelementes vorgesehen.

Die Erfindung wird nachstehend anhand von Ausführungsbeispielen beschrieben. Es zeigt

Fig. 1 ein erstes Ausführungsbeispiel einer Explosionsschutzanordnung für Halbleiter-Bauelemente schematisch im Vertikalschnitt,

Fig. 2 ein zweites Ausführungsbeispiel einer Explosionsschutzanordnung für Halbleiter-Bauelemente mit zugeordneten Sicherungselementen schematisch in Draufsicht und

Fig. 3 eine Explosionsschutzanordnung für Halbleiter-Bauelemente in einem Vertikalschnitt längs der Linie III-III in Fig. 2.

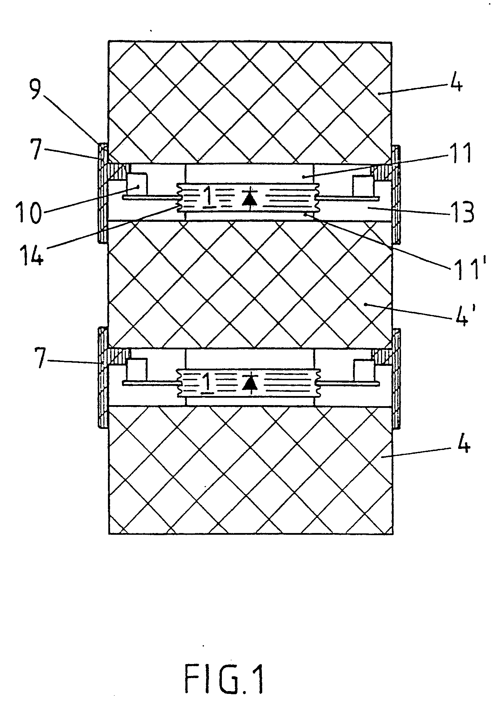

Gemäß Fig. 1 ist zwischen je zwei Kühlelementen 4 und 4' je ein scheibenförmiges Halbleiter-Bauelement 1 zentrisch angeordnet. Zur elektrischen Kontaktierung sowie zur Abführung der in diesem Halbleiter-Bauelement freiwerdenden Verlustwärme sind zwischen den Kontaktflächen des Halbleiter-Bauelementes und den Kühlelementen 4 und 4' gutleitende Kontaktscheiben 11 und 11' angeordnet.

Das Halbleiter-Bauelement 1 ist mit Abstand von einem Explosionsschutzmantel 7 umschlossen, der gleichzeitig die beiden dem Halbleiter-Bauelement zugeordneten Kühlelemente 4 und 4' teilweise und dichtanliegend umschließt. Der Explosionsschutzmantel 7 schließt somit einen das Halbleiter-Bauelement 1 umgebenden Berstraum 13 zwischen den Kühlelementen 4 und 4' splitterdicht ab und wirkt gleichzeitig als Zentrierung für diese Kühlelemente. An dem Explosionsschutzmantel 7 ist ein kurzes Zentriersegment 9 angeordnet, das sich von dem Umfangsteil des Explosionsschutzmantels im wesentlichen senkrecht nach innen, d. h. in den Berstraum 13 erstreckt und für das Kühlelement 4 eine Anlegekante bildet.

Der Berstraum 13 ist üblicherweise mit Luft gefüllt. Er kann auch mit einem gasförmigen oder festen Lichtbogen-Löschmittel, wie z. B. SF$_6$-Gas oder Quarzsand, gefüllt sein.

Der Explosionsschutzmantel 7 besteht aus einem elektrisch isolierenden, nichtbrennbaren, lichtbogenbeständigen Werkstoff. Als Werkstoffe eignen sich zum Beispiel Quarz, Keramik, Asbest, Silastomer, Silikonkautschuk, Gießharz, das ggf. durch Glasfasern verstärkt ist, und Polytetrafluorethylen. Die Dicke des Explosionsschutzmantels sollte so bemessen sein, daß sie mindestens einem Druck von 10 bar standhält.

Das scheibenförmige Halbleiter-Bauelement 1 weist am kreiszylindrischen Mantelteil, das z. B. aus einem Keramik-Isolator besteht, Rillen 14 auf. In diese Rillen greift ein Halbleiter-Zentrierelement 10 ein, das an dem Zentriersegment 9 durch Klemmen, Verschrauben oder dgl. befestigt werden kann. Dieses Halbleiter-Zentrierelement 10 gewährleistet, daß das Halbleiter-Bauelement 1 eine vorbestimmte zentrische Lage zwischen den beiden Kühlelementen 4 und 4' einnimmt.

Wie in Fig. 1 angedeutet, können mehrere Halbleiter-Bauelemente 1 und Kühlelemente 4, 4' mit der beschriebenen Explosionsschutzanordnung hintereinandergeschaltet sein. Eine gute elektrische Kontaktierung und Wärmeübertragung zwischen Halbleiter-Bauelementen und Kühlelementen kann z. B. in bekannter Weise durch Anpressen mittels einer nicht dargestellten Einspannvorrichtung bewirkt werden.

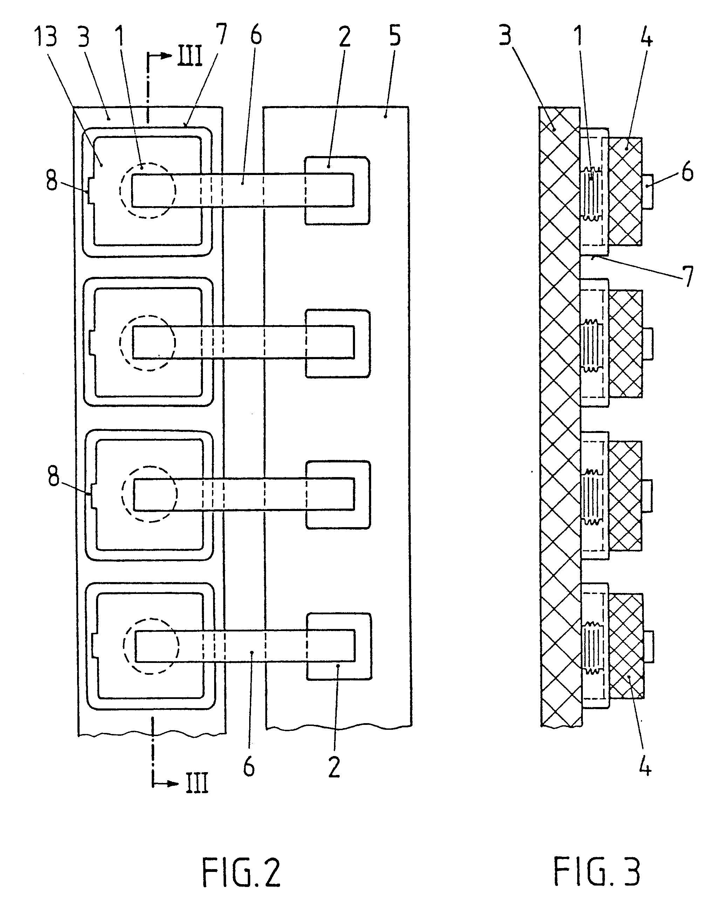

Gemäß eines weiteren, in den Fig. 2 und 3 dargestellten Ausführungsbeispiels der Erfindung sind mehrere Halbleiter-Bauelemente 1 auf einer gemeinsamen Kühlschiene 3 angeordnet. Diese Kühlschiene dient gleichzeitig als eine Stromzuführung für die Halbleiter-Bauelemente. Eine zweite Stromzuführung zu den Halbleiter-Bauelementen erfolgt über die Kühlelemente 4, welche über Stromleiter 6 und nur schematisch angedeutete, elektrische Sicherungen 2 mit einer Stromschiene 5 elektrisch verbunden sind.

Die im Querschnitt im wesentlichen rechteckförmigen Explosionsschutzmäntel 7 weisen Sollbruchstellen 8 auf. Diese Sollbruchstellen sind räumlich den Sicherungen 2 gegenüberliegend angeordnet; sie werden zweckmäßig an einer solchen Stelle angebracht, an der ein Bersten unschädlich für andere Bauelemente, Sicherungen oder Schaltelemente ist.

Entsprechend der Darstellung in Fig. 3 wird bei dieser Ausführung nur das Kühlelement 4 teilweise von dem Explosionsschutzmantel 7 umschlossen.

Die Wirkungsweise der erfindungsgemäßen Explosionsschutzanordnung sei anhand der Fig. 2 erläutert. Es wird angenommen, daß innerhalb eines defekten Halbleiter-Bauelementes eine Lichtbogenbildung eintritt, die zu einer explosionsartigen Zerstörung dieses Bauelementes führt. Bauelementsplitter werden durch den Berstraum 13 gegen die Wandung des Explosionsschutzmantels 7 geschleudert, wo sie am Weiterflug gehindert werden. Sie können somit weder benachbarte Halbleiter-Bauelemente 1 noch Sicherungen 2 beschädigen.

Ohne diesen Explosionsschutzmantel ist die Gefahr groß, daß benachbarte Bau- und Schaltelemente kettenreaktionsartig zerstört werden und Sicherungen auch bei Überstrom nicht auslösen.

Der relativ große Berstraum 13 ermöglicht einen starken Abbau des Überdruckes der Explosionsgase.

Ein Austreten des Lichtbogens aus dem Berstraum 13 oder ein Übergreifen auf andere Bauelemente oder brennbare Gegenstände in der Nachbarschaft wird durch den aus einem lichtbogenbeständigen Werkstoff hergestellten Explosionsschutzmantel ebenfalls verhindert.

Eine gemäß einer besonderen Ausgestaltung der Erfindung vorgesehene Sollbruchstelle 8 im Explosionsschutzmantel 7 gewährleistet eine erhöhte Sicherheit bezüglich des Schutzes explosionsempfindlicher Bau-, Sicherungs- und Schaltelemente in der Nachbarschaft des defekt gewordenen Halbleiter-Bauelementes. Falls der Explosionsschutzmantel 7 bersten sollte, so erfolgt dies an einer dafür vorgesehenen Stelle, an der keine Folgeschäden zu erwarten sind.

Die Erfindung ist auf das in den Zeichnungen Dargestellte selbstverständlich nicht beschränkt. So könnte der Explosionsschutzmantel 7 anstelle eines kreis- oder rechteckförmigen Querschnitts z. B. auch einen ovalen oder dreieckförmigen Querschnitt aufweisen. Um den Berstraum 13 besser abzudichten, könnte ein dem Zentriersegment 9 entsprechendes, am Kühlelement 4' und am Explosionsschutzmantel 7 dicht anliegendes Segment vorgesehen sein.

Die Abdichtung kann auch als Labyrinthdichtung ausgeführt werden. Der Plasmastrahl wird dabei mehrmals umgelenkt und gekühlt. Die Abschirmung muß dabei nicht gasdicht sein, jedoch lichtbogendicht.

Bezeichnungsliste

| | | |
|---|---|---|
| 1 | = | Halbleiter-Bauelemente |
| 2 | = | Sicherung |
| 3 | = | Kühlschiene bzw. Stromzuführungsanordnung |

| | | |
|---|---|---|
| 4, 4' | = | Kühlelemente bzw. Stromzuführungsanordnung |
| 5 | = | Stromschiene |
| 6 | = | Stromleiter |
| 7 | = | Explosionsschutzmantel |
| 8 | = | Sollbruchstelle |
| 9 | = | Zentriersegment |
| 10 | = | Halbleiter-Zentrierelement |
| 11, 11' | = | Kontaktscheiben |
| 13 | = | Berstraum |
| 14 | = | Rillen |

**Patentansprüche**

1. Explosionsgeschützte Halbleiter-Bauelement-Anordnung

a) mit mindestens einem gekapselten, scheibenförmigen Halbleiter-Bauelement (1), das ein Gehäuse mit einem kreiszylindrischen Mantelteil aus einem Isolator aufweist,

b) mit einem Explosionsschutzmantel (7), der einen Berstraum (13) um dieses Mantelteil umschließt,

dadurch gekennzeichnet,

c) daß das Halbleiter-Bauelement (1) mit mindestens einem Kühlelement (4, 4') in elektrischer und wärmeleitender Verbindung steht,

d) daß der Explosionsschutzmantel (7) mindestens ein Kühlelement (4) an dessen Außenumfang mindestens teilweise umschließt und zentriert und

e) daß der Explosionsschutzmantel mindestens ein Zentriersegment (9) für eine Zentrierung des Halbleiter-Bauelements (1) innerhalb des Explosionsschutzmantels aufweist.

2. Explosionsgeschützte Halbleiter-Bauelement-Anordnung nach Anspruch 1, dadurch gekennzeichnet, daß der Berstraum (13) zwischen Halbleiter-Bauelement (1) und Explosionsschutzmantel (7) mit einem gasförmigen oder festen Lichtbogen-Löschmittel gefüllt ist, insbesondere daß das Löschmittel Quarzsand oder SF₆-Gas ist.

**Claims**

1. Explosion-protected semiconductor component arrangement

a) having at least one encapsulated, disc-shaped semiconductor component (1) which possesses a housing having a jacket section, in the shape of a cylinder of circular cross-section, made of an insulator and

b) having an explosion-protective jacket (7) which surrounds a bursting space (13) around the said jacket section

characterised in that

c) the semiconductor component (1) is electrically and heat-conductively connected to at least one cooling element (4, 4'),

d) the explosion-protective jacket (7) at least partially surrounds at least one cooling element (4) at the outer periphery of the said element and serves to centre the element, and

e) the explosion-protective jacket possesses at least one centring segment (9) for centring the semiconductor component (1) within the explosion-protective jacket.

2. Explosion-protected semiconductor component arrangement according to claim 1, characterised in that the bursting space (13) between the semiconductor component (1) and the explosion-protective jacket (7) is filled with a gaseous or solid arc-extinguishing material, the said material being, in particular, quartz sand or SF₆ gas.

**Revendications**

1. Dispositif à composant semiconducteur protégé contre l'explosion,

a) avec au moins un composant semiconducteur (1) encapsulé, en forme de disque, qui comporte un boîtier avec une partie enveloppe cylindrique circulaire en matériau isolant,

b) avec une enveloppe (7) de protection contre l'explosion, qui délimite une chambre d'explosion (13) autour de cette partie enveloppe,

caractérisé en ce que

c) le composant semiconducteur (1) est en liaison électrique et thermique avec au moins un élément de refroidissement (4, 4'),

d) l'enveloppe (7) de protection contre l'explosion entoure au moins partiellement au moins un élément de refroidissement (4), à sa périphérie, et en assure le centrage, et

e) l'enveloppe (7) de protection contre l'explosion présente au moins un segment de centrage (9) pour un centrage du composant semiconducteur (1) à l'intérieur de l'enveloppe de protection contre l'explosion.

2. Dispositif à composant semiconducteur protégé contre l'explosion selon la revendication 1, caractérisé en ce que la chambre d'explosion (13) entre le composant semiconducteur (1) et l'enveloppe (7) de protection contre l'explosion est remplie d'un agent gazeux ou solide d'extinction de l'arc électrique, en particulier que l'agent d'extinction est du sable de quartz ou du gaz SF₆.

FIG.1

FIG.2

FIG. 3